# EUROPÄISCHE PATENTANMELDUNG

(11) **EP 2 190 274 A2**
(43) Veröffentlichungstag der Anmeldung: **26.05.2010**
(21) Anmeldenummer: 09012244.1
(22) Anmeldetag: 26.09.2009
(51) Int. Cl.: H05K 7/14

(54) **Anordnung mit Leistungshalbleitermodul und Treibereinrichtung**

(30) Priorität: 19.11.2008 DE 102008057831
(71) Anmelder: SEMIKRON Elektronik GmbH & Co. KG, 90431 Nürnberg (DE)
(72) Erfinder: Lederer, Marco, 90453 Nürnberg (DE); Steger, Jürgen, 91355 Hiltpoltstein (DE)

(57) **Zusammenfassung**

Die Erfindung beschreibt eine Anordnung mit Leistungshalbleitermodulen, mit Substraten, mit Hilfs- und Lastanschlusselementen, wobei an einem Lastanschlusselement ein Sensor beweglich angeordnet ist, und mit einer Treibereinrichtung, mit Leiterplatten und mit einem Gehäuse mit einer Abdeckung und mit in dem Gehäuse befindlichen Stütz- und Anschlagelementen zur Positionierung der Leiterplatte. Die Treibereinrichtung ist oberhalb der Leistungshalbleitermodule angeordnet. Die Leiterplatten sind mit dem Substrat mittels Kontaktelementen, in Form von ersten Druckfederkontakten, kraftschlüssig elektrisch leitend verbunden. Die Stützelemente mit den Anschlagelementen dienen zur Befestigung und Begrenzung der lateralen Beweglichkeit der Leiterplatten der Treibereinrichtung. Die Leiterplatten sind mit den Stützelementen innerhalb des Gehäuses mittels Befestigungselementen lateral beweglich verbunden. Das Gehäuse und/oder die Abdeckung der Treibereinrichtung sind vorzugsweise abdichtend auf den Leistungshalbleitermodulen angebracht und schützen somit die Treibereinrichtung und die Leistungshalbleitermodule vor schädlichen Umwelteinflüssen.

## Beschreibung

Die Erfindung beschreibt eine Anordnung mit einem oder einer Mehrzahl von Leistungshalbleitermodulen und einer Treibeinrichtung hierzu. Vorzugsweise bildet diese Anordnung einen zusätzlichen Schutz der Treibereinrichtung und des Leistungshalbleitermoduls vor negativen Einflüssen durch Schwingungen, Erwärmung und Umwelt aus.

Grundsätzlich bekannt ist die Anordnung von Leistungshalbleitermodulen mit darauf montierten Treibereinrichtungen und die Verwendung von isolierenden Gehäusen mit Deckel bei Leistungshalbleitermodulen.

Die DE 10 2004 025 609 A1 offenbart ein Leistungshalbleitermodul mit einem rahmenartigen isolierenden Gehäuse und einem einstückig damit verbundenen Deckel. Dieses Gehäuse offenbart Ausformungen zur Positionierung und Fixierung der Leistungs-und Hilfsanschlüsse des Leistungshalbleitermoduls. Hierzu weist der Deckel mit Ausnehmungen kombinierte Ausformungen auf, die zur Halterung und Durchführung der als Kontaktfedern ausgebildeten Hilfsanschlüsse dienen. Die bandartigen Leistungsanschlüsse werden ebenfalls in einer Ausformung des Gehäuses fixiert.

Nachteilig an dieser Ausgestaltung eines derartigen rahmenartigen isolierenden Gehäuses mit einem Deckel für Leistungshalbleitermodule ist, dass diese Ausgestaltung keinen Schutz gegen schädliche Umwelteinflüsse für die Leistungshalbleitermodule bietet.

Gemäß dem Stand der Technik werden Leiterplatten einer Treibereinrichtung nur partiell über Anschraubpunkte auf den Leistungshalbleitermodulen fixiert und können an den nicht fixierten Bereichen und Überhängen schwingen. Weiterhin weisen die Leiterplatten der Treibereinrichtung keinen Schutz gegen schädliche Umwelteinflüsse auf. Ausgestaltungen mit einer Mehrzahl parallel angeordneter und voneinander beabstandeter Leiterplatten für eine Treibereinrichtung werden über Steckverbindungen realisiert. Hierzu werden Bauteile, wie z.B. Widerstände auf den Leiterplatten über Konvektion von der benachbarten Leiterplatte erwärmt.

Nachteilig am Stand der Technik ist die erhöhte Gefahr der Beschädigung der Treibereinrichtung durch Schwingungen der nicht fixierten Bereiche der Leiterplatten. Schädliche Umwelteinflüsse wirken sich nachteilig auf die Lebensdauer der Treibereinrichtung aus. Die Erwärmung der Bauteile auf den Leiterplatten reduziert die Lebensdauer der Leiterplatten bzw. der Bauteile hierauf selbst.

Der vorliegenden Erfindung liegt die Aufgabe zu Grunde eine Anordnung mit mindestens einem Leistungshalbleitermodul und einer Treibereinrichtung anzugeben, wobei die negativen Einflüsse von Schwingungen, Erwärmung und/oder Umwelt reduziert werden und die Treibereinrichtung mit den Leistungshalbleitermodulen elektrisch leitend verbunden ist.

Diese Aufgabe wird erfindungsgemäß gelöst, durch eine Anordnung mit den Merkmalen des Anspruchs 1. Bevorzugte Ausführungsformen sind in den abhängigen Ansprüchen beschrieben.

Der erfinderische Gedanke geht von einer Anordnung mit mindestens einem Leistungshalbleitermodul und einer Treibereinrichtung mit Befestigungselementen für die mindestens eine Leiterplatte der Treibereinrichtung aus.

Das Leistungshalbleitermodul weist mindestens ein Substrat, mit Hilfs- und Lastanschlusselementen auf. Vorzugweise weist das Leistungshalbleitermodul weiterhin mindestens einen beweglich angeordneten Sensor an mindestens einem Lastanschlusselement auf.

Die Treibereinrichtung weist mindestens eine Leiterplatte, ein Gehäuse und eine Abdeckung auf. Weiterhin weist das Gehäuse Stützelemente und seitliche Anschlagelemente auf. Die erfindungsgemäßen Stütz- und Anschlagelemente erfüllen hierbei die Aufgabe der Befestigung und Positionierung der Leiterplatten der Treibereinrichtung. Erfindungsgemäß sind die Leiterplatten mit den Stützelementen innerhalb des Gehäuses lateral beweglich über Befestigungselemente verbunden. Vorzugweise sind die Befestigungselemente als Schraub- oder Klemmverbindung ausgebildet. Die erfindungsgemäßen Anschlagelemente beschränken die seitliche Bewegung der Leiterplatten der Treibereinrichtung, um die elektrische Kontaktierung der Kontaktflächen der Leiterplatten mit den Kontaktelementen, erste Druckfederkontakte der Hilfsanschlüsse, der Leistungshalbleitermodule zu gewährleisten.

Die Treibereinrichtung ist hierbei oberhalb der Leistungshalbleitermodule angeordnet. Die Leiterplatten sind mit dem Substrat mittels der Kontaktelemente, erste Druckfederkontakte der Hilfsanschlüsse, kraftschlüssig elektrisch leitend verbunden und weisen hierzu pro Kontaktelement eine Kontaktfläche auf.

Bei einer Mehrzahl von Leiterplatten in der Treibereinrichtung weisen die Leiterplatten mindestens eine Verbindung mittels mindestens einer Steckverbindung oder mittels mindestens eines zweiten Druckfederkontakts untereinander auf. Vorzugsweise verbinden zweite Druckfederkontakte die Leiterplatten der Treibereineinrichtung untereinander. Derartige zweite Druckfederkontakte sind vorzugsweise in zylindrischen Federschächten in den Stützelementen innerhalb des Gehäuses der Treibereinrichtung angeordnet.

Weiterhin weisen die Stützelemente innerhalb des Gehäuses der Treibereinrichtung vorzugsweise konusförmige Elemente zur Fixierung der beweglich angeordneten Sensoren an den Lastanschlusselementen, welche in passende Gegenelemente an den Sensoren greifen, auf. Somit sind mit dieser Fixierung der beweglich angeordneten Sensoren an den Lastanschlusselementen die Kontakte der Sensoren positioniert und ebenfalls mit einer Leiterplatte der Treibereinrichtung elektrisch leitend verbunden.

Die Abdeckung der Treibereinrichtung weist mindestens ein Befestigungselement auf, mit dem die Abdeckung mit den Leistungshalbleitermodulen verbunden ist. Vorzugweise ist das Befestigungselement als Schraubverbindung ausgebildet. Diese Verbindung beaufschlagt vorzugsweise die ersten und zweiten Druckfederkontakte mit Druck, wodurch die elektrische Kontaktierung der Leiterplatten untereinander und mit den Leistungshalbleitermodulen erzielt wird.

Ebenso bevorzugt ist es, wenn die Abdeckung an der Oberseite Einbuchtungen für die Versenkung der Befestigungselemente aufweist, die mit den Leistungshalbleitern verbunden sind. An der der Leiterplatte zugewandten Unterseite der Abdeckung weist diese bevorzugt einstöckige rechteckige Körper auf. Vorzugsweise besteht die Abdeckung selbst aus einem thermischleitfähigen Material, wie Aluminium oder einem geeigneten Kunststoff. Somit weist die Abdeckung eine Wärmeleitfähigkeit auf, die mit Hilfe der rechteckigen Körper und Wärmeleitpads an deren Enden, die Wärme von Bauelementen auf den Leiterplatten zur Abdeckung abführt.

Vorzugsweise weist die Treibereinrichtung weiterhin eine Dichteinrichtung auf, die zur Abdichtung gegen schädliche Umwelteinflüsse dient, dabei werden das Gehäuse und/oder die Abdeckung abdichtend auf den Leistungshalbleitermodulen angeordnet. Vorzugweise besteht das Material zur Abdichtung der Abdeckung und/oder des Gehäuses aus Silikon oder Silikonschaum.

Die erfinderische Lösung wird an Hand der Ausführungsbeispiele der Fig. 1 bis 8 weiter erläutert.

Fig. 1 zeigt in dreidimensionaler Darstellung eine erfindungsgemäße Anordnung von drei Leistungshalbleitermodulen und einer gemeinsamen Treibereinrichtung.

Fig. 2 zeigt im Querschnitt die Anordnung gemäß Fig. 1 in der Seitenansicht.

Fig. 3 zeigt in dreidimensionaler Darstellung die Anordnung gemäß Fig. 1 ohne Abdeckung mit Leiterplatte.

Fig. 4 zeigt in dreidimensionaler Darstellung die Treibereinrichtung mit Leiterplatten der Anordnung gemäß Fig. 1.

Fig. 5 zeigt in dreidimensionaler Darstellung das Gehäuse mit den Stützelementen der Treibereinrichtung.

Fig. 6 zeigt im Querschnitt die Anordnung gemäß Fig. 1 in der Rückansicht.

Fig. 7 zeigt in dreidimensionaler Darstellung die Abdeckung der Treibereinrichtung.

Fig. 8 zeigt schematisch im Querschnitt einen Ausschnitt einer Treibereinrichtung.

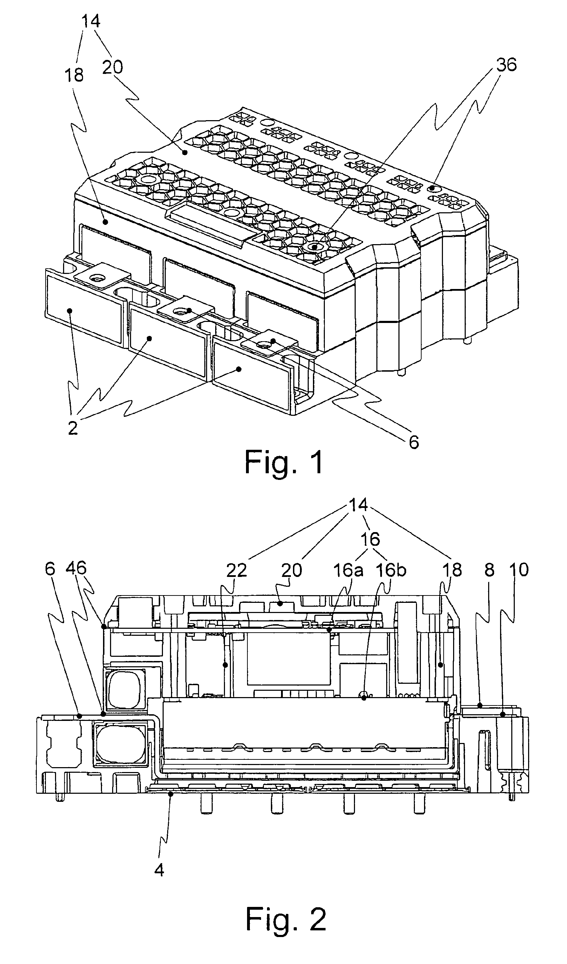

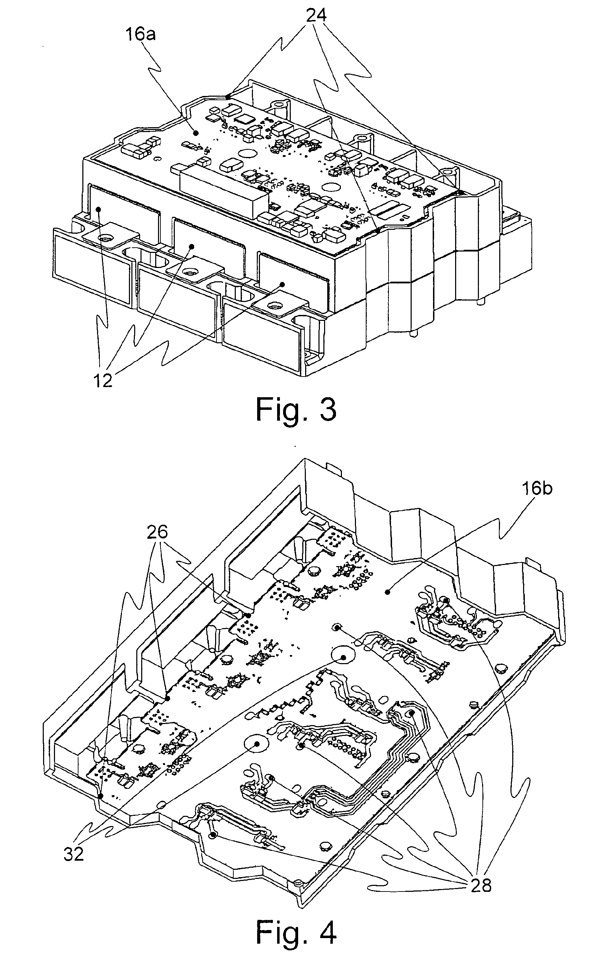

Fig. 1 zeigt in dreidimensionaler Darstellung eine erfindungsgemäße Anordnung von drei Leistungshalbleitermodulen (2) und einer gemeinsamen Treibereinrichtung (14). Die Treibereinrichtung (14) ist hier mit dem Gehäuse (18) und der Abdeckung (20) dargestellt und erstreckt sich über alle drei Leistungshalbleitermodulen (2). Bewegliche angeordnete Sensoren (Fig. 3: 12) zur Strommessung sind an den Lastanschlusselementen (6) angeordnet.

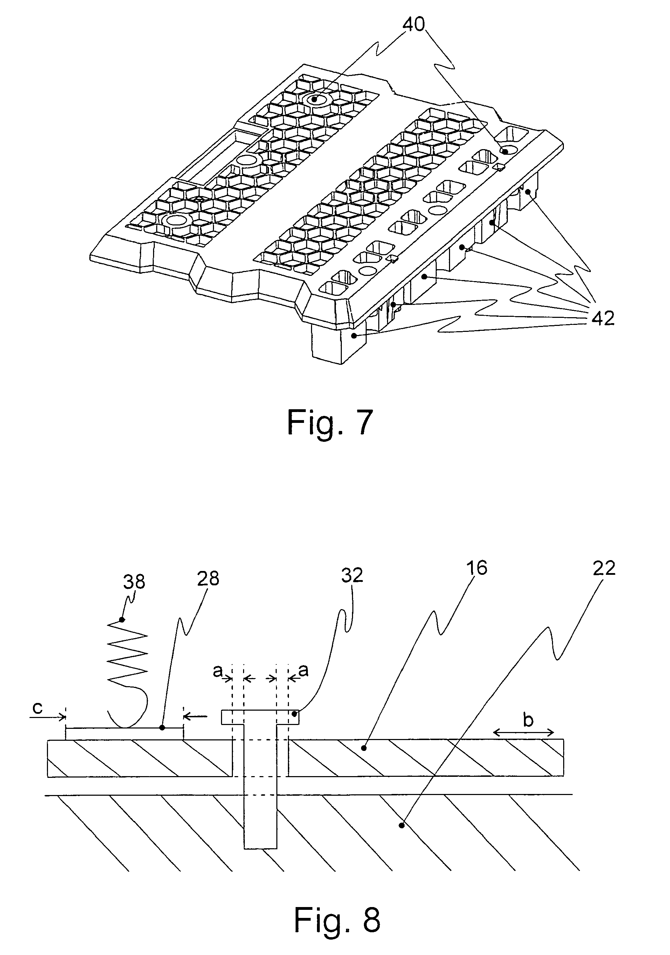

Die Befestigungselemente (36) der Abdeckung (20) beaufschlagen die ersten Druckfederkontakte (Fig. 7: 38) auf den Leistungshalbleitermodulen (2) mit Druck und gewährleisten somit die sichere elektrische Kontaktierung der Leiterplatte (16b) mit den Leistungshalbleitermodulen (2).

Fig. 2 zeigt im Querschnitt die Anordnung von einem Leistungshalbmodul (2) mit einem Substrat (4) und einer Treibereinrichtung (14) mit zwei Leiterplatten (16 a/b), einem Gehäuse (18) mit Stützelementen (22) und einer Abdeckung (20), sowie die Lastanschlusselemente (6, 8, 10) des Leistungshalbleitermoduls (2) in der Seitenansicht.

Die Treibereinrichtung weist hier eine Dichteinrichtung (46) auf, die zur Abdichtung gegen schädliche Umwelteinflüsse dient. Dabei sind das Gehäuse (18) und/oder die Abdeckung (20) abdichtend auf den Leistungshalbleitermodulen (2) angeordnet. Für die Dichteinrichtung (46) wird Silikon oder Silikonschaum als Material verwendet.

Fig. 3 zeigt in dreidimensionaler Darstellung die Anordnung gemäß der Figur 1 ohne Abdeckung (20) mit den Leiterplatten (16).

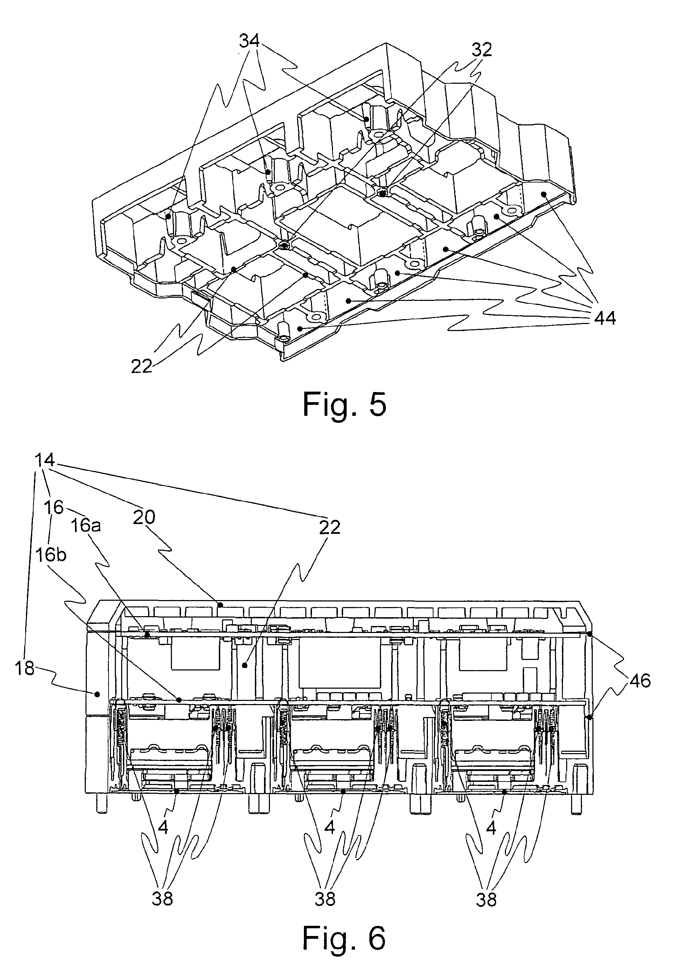

Das Gehäuse (18) und die Stützelemente (22) der Treibereinrichtung (14) weisen laterale Anschlagelemente (24, Fig. 4: 26) für die Leiterplatten (16) der Treibereinrichtung (14) auf, um die laterale Bewegung (Fig. 8: 44) der Leiterplatten (16) auf maximal 20 von 100 der lateralen Ausdehnung c der Kontaktflächen (Fig. 8: 28) für die ersten Druckfederkontakte (Fig. 6: 38) einzugrenzen.

Die Kontaktflächen (Fig. 4: 28) dienen zur elektrischen Kontaktierung über die ersten Druckfederkontakte (Fig. 6: 38) zwischen der Leiterplatte (16b) der Treibereinrichtung (14) und den Leistungshalbleitermodulen (2).

Fig. 4 zeigt in dreidimensionaler Darstellung die Treibereinrichtung (14) mit der Leiterplatte (16b) der Anordnung gemäß der Figur 1. Die lateralen Anschlagelemente (24, 26) begrenzen die laterale Bewegung der Leiterplatten (16) auf maximal 20% Prozent der lateralen Ausdehnung c der Kontaktflächen (28) und gewährleistet somit die elektrische Kontaktierung der Leiterplatte (16b) der Treibereinrichtung (14) über die ersten Druckfederkontakte (Fig. 6: 38) mit den Leistungshalbleitermodulen (2).

Die beiden Leiterplatten (16) sind mit den Stützelementen (22) innerhalb des Gehäuses (18) mittels zweier Befestigungselemente (32) lateral beweglich begrenzt durch die Anschlagelemente (24, 26) verbunden.

Fig. 5 zeigt in dreidimensionaler Darstellung das Gehäuse (18) mit den Stützelementen (22) der Treibereinrichtung (14). Die Befestigungselemente (32) dienen zu Aufnahme der Schraubverbindung oder der Klemmverbindung zur Befestigung der Leiterplatten (16) an den Stützelementen (22), wobei gleichzeitig deren laterale Beweglichkeit b in gewissen Grenzen erhalten bleibt.

Die konusförmigen Elemente (34) an den Stützelementen (22) dienen zum Positionieren der beweglichen Sensoren (12) an den Lastanschlusselementen (6). Weiterhin sind mit der Positionierung der beweglichen Sensoren (12) an den Lastanschlusselementen (6) die Kontakte der Sensoren (12) positioniert und mit einer Leiterplatte (16b) der Treibereinrichtung (14) elektrisch leitend verbunden.

Fig. 6 zeigt im Querschnitt die Anordnung gemäß der Figur 1 von drei Leistungshalbmodulen (2) mit je einem Substrat (4) und einer Treibereinrichtung (14) mit einer Abdeckung (20), einem Gehäuse (18) mit Stützelementen (22) und hier zwei Leiterplatten (16) der Treibereinrichtung (14) in der Rückansicht.

Die ersten Druckfederkontakte (38) sind in zylindrischen Federschächten untergebracht und bilden die elektrische Kontaktierung der Leistungshalbleitermodule (2) mit den Leiterplatten (16) der Treibereinrichtung (14).

Fig. 7 zeigt in dreidimensionaler Darstellung die Abdeckung (20) der Treibereinrichtung (14) mit den Einbuchtungen (40) für die Befestigungselemente (36) auf der Oberseite der Abdeckung (20).

Die rechteckigen Körper (42) auf der Unterseite der Abdeckung (20) der Treibereinrichtung (14) entsprechen der Form der Aussparungen (Fig. 5: 44) der Stützelemente (22) und dienen zur zusätzlichen Wärmeabfuhr von Bauelementen auf den Leiterplatten (16) über die Abdeckung (20), wobei die Abdeckung (20) und damit die rechteckigen Körper (42) aus einem thermischleitfähigem Material, wie Aluminium oder einem thermischleitfähigem Kunststoff, besteht.

Fig. 8 zeigt schematisch im Querschnitt einen Ausschnitt einer Treibereinrichtung (14) mit der Befestigungseinrichtung (32) einer Leiterplatte (16) der Treibereinrichtung (14) an einem Stützelement (22) innerhalb des Gehäuses (18).

Die laterale Beweglichkeit b der Leiterplatte (16) gegenüber dem Gehäuse (18) bzw. den Stützelement (22) ist mittels Anschlagelementen (Fig. 3: 24, Fig. 4: 26) begrenzt.

Die Grenze für die laterale Beweglichkeit b bestimmt sich aus der Dimensionierung der Kontaktflächen (28) auf den Leiterplatten (16) für die ersten Druckfederkontakte (38).

Es muss sicher gestellt sein, dass die ersten Druckfederkontakte (38) auch an den Grenzen der lateralen Beweglichkeit b sicheren elektrischen Kontakt zu den zugeordneten Kontaktflächen (28) aufweisen. Daher bestimmt sich die maximale laterale Beweglichkeit b zu einem Wert kleiner 20% der entsprechenden Ausdehnung c der Kontaktflächen (28), wobei selbstverständlich davon auszugehen ist, dass alle Kontaktflächen (28) gleiche laterale Ausdehnungen c aufweisen.

Die Befestigungseinrichtung (32), hier schematisch als Schraubverbindung dargestellt, gestattet der Leiterplatte (16) eine laterale Beweglichkeit b von jeweils der Ausdehnung a in beide Richtungen von der Mittellage aus betrachtet. Bei einer gegeben lateralen Ausdehnung c der Kontaktflächen (28) ergibt sich eine gesamte laterale Beweglichkeit von b = 2a < 0,2c.

Hierdurch ist einerseits die sichere elektrische Kontaktierung des ersten Druckfederkontaktes (38) gewährleistet und andererseits können sich die Leiterplatten (16) gegenüber dem Gehäuse (18) in den gegeben Grenzen bewegen, während die Nachteile einer starren Verbindung vermieden werden.

## Patentansprüche

1. Anordnung mit
mindestens einem Leistungshalbleitermodul (2), mit mindestens einem Substrat (4), mit Hilfs- (38) und Lastanschlusselementen (6, 8, 10), wobei an mindestens einem Lastanschlusselement (6) ein Sensor (12) beweglich angeordnet ist, und
mit einer Treibereinrichtung (14), mit mindestens einer Leiterplatte (16) und mit einem Gehäuse (18) mit einer Abdeckung (20) und mit in dem Gehäuse (18) befindlichen Stütz- (22) und Anschlagelementen (24, 26) zur Positionierung der mindestens einen Leiterplatte (16),
wobei die Treibereinrichtung (14) oberhalb des mindestens einen Leistungshalbleitermoduls (2) angeordnet ist und die Leiterplatte (16) mit dem Substrat (4) mittels ersten Druckfederkontakten (38) als Hilfsanschlusselement kraftschlüssig elektrisch leitend verbunden ist und hierzu pro ersten Druckfederkontakt (38) eine Kontaktfläche (28) auf einer Leiterplatte (16b) aufweist und
wobei die Anschlagelemente (24, 26) die laterale Beweglichkeit b der Leiterplatten (16) auf maximal 20 von 100 der lateralen Ausdehnung c der Kontaktflächen (28) begrenzen und
wobei die mindestens eine Leiterplatte (16) mit Stützelementen (22) innerhalb des Gehäuses (18) mittels einer Mehrzahl von Befestigungselementen (32) lateral beweglich verbunden ist.

2. Anordnung nach Anspruch 1,
wobei die Befestigungselemente (32) für die mindestens eine Leiterplatte (16) als Klemmverbindung oder als Schraubverbindung ausgebildet sind.

3. Anordnung nach den Ansprüchen 1 oder 2,
wobei eine Mehrzahl von Leiterplatten (16) mittels mindestens einer Steckverbindung oder mittels mindestens eines zweiten Druckfederkontakts untereinander elektrisch leitend verbunden sind,
wobei die zweiten Druckfederkontakte in zylindrischen Federschächten in den Stützelementen (22) innerhalb des Gehäuses (18) der Treibereinrichtung (14) angeordnet sind.

4. Anordnung nach Anspruch 1,
wobei durch an den Stützelementen (22) angeordnete konusförmige Elemente (34) und mittels passender Gegenelemente an den Sensoren (12) die beweglichen Sensoren (12) an den Lastanschlusselementen (6, 8, 10) positioniert sind,
wobei mit der Positionierung der beweglichen Sensoren (12) ebenfalls deren elektrische Kontakte fixiert sind und mit einer Leiterplatte (16) elektrisch leitend verbunden sind.

5. Anordnung nach Anspruch 1,
wobei die Abdeckung (20) über mindestens ein Befestigungselement (36) mit den Leistungshalbleitermodulen (2) verbunden ist,
wobei das Befestigungselement (36) aus mindestens einer Schraubverbindung besteht,
wobei durch die Befestigung der Abdeckung (20) auf den Leistungshalbleitermodulen (2) die ersten (38) und zweiten Druckfederkontakte mit Druck beaufschlagt sind und somit die elektrische Kontaktierung der Leiterplatten (16) untereinander und mit den Leistungshalbleitermodulen (2) erfolgt.

6. Anordnung nach Anspruch 1 oder 5,
wobei die Abdeckung (20) an der Oberseite Einbuchtungen (40) für die Befestigungselemente (36) und an der Unterseite rechteckige Körper (42) aufweist,
wobei die rechteckigen Körper (42) den Aussparungen (44) in den Stützelementen (22) und dem Gehäuse (18) entsprechen.

7. Anordnung nach Anspruch 1,
wobei die Treibereinrichtung (14) eine Dichteinrichtung (46) zur Abdichtung gegen Umwelteinflüsse aufweist,
wobei das Gehäuse (18) und/oder die Abdeckung (20) abdichtend auf den Leistungshalbleitermodulen (2) angeordnet sind.

8. Anordnung nach Anspruch 7,
wobei für die Abdichtung Silikon und/oder Silikonschaum angewandt ist.

9. Anordnung nach Anspruch 1,
wobei die Abdeckung (20) sich aus einem thermisch leitfähigen Material, wie Aluminium oder einem thermisch leitfähigen Kunststoff besteht und
wobei an den Enden der rechteckigen Körper (42) Wärmeleitpads angeordnet sind.
